(19) Europäisches Patentamt
European Patent Office
Office européen des brevets

(11) EP 4 151 402 A1

(12) EUROPEAN PATENT APPLICATION
published in accordance with Art. 153(4) EPC

(43) Date of publication:
**22.03.2023 Bulletin 2023/12**

(21) Application number: **21805074.8**

(22) Date of filing: **26.03.2021**

(51) International Patent Classification (IPC):
***B32B 9/00*** *(2006.01)* ***B32B 27/00*** *(2006.01)*
***H05B 33/04*** *(2006.01)* ***H01L 51/50*** *(2006.01)*

(52) Cooperative Patent Classification (CPC):
**B32B 9/00; B32B 27/00; H05B 33/04; H10K 50/00**

(86) International application number:
**PCT/JP2021/012886**

(87) International publication number:
**WO 2021/229930 (18.11.2021 Gazette 2021/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **12.05.2020 JP 2020083687**

(71) Applicant: **Toyo Seikan Group Holdings, Ltd.**
**Shinagawa-ku**
**Tokyo 141-8627 (JP)**

(72) Inventors:
- **OKUYAMA, Shinpei**
  **Yokohama-shi, Kanagawa 240-0062 (JP)**
- **TAKAYAMA, Keisuke**
  **Yokohama-shi, Kanagawa 240-0062 (JP)**
- **NANGOU, Shunya**
  **Yokohama-shi, Kanagawa 240-0062 (JP)**
- **OZAWA, Kazumi**
  **Yokohama-shi, Kanagawa 240-0062 (JP)**
- **KAWANISHI, Misato**
  **Yokohama-shi, Kanagawa 240-0062 (JP)**

(74) Representative: **J A Kemp LLP**
**80 Turnmill Street**
**London EC1M 5QU (GB)**

# (54) MOISTURE BARRIER LAMINATED FILM

(57) A moisture barrier laminated film 10 includes: a plastic film (A) having an inorganic barrier layer (A1); a moisture trapping layer (B) containing an alkali component; and a coating layer (C) provided between the inorganic barrier layer (A1) and the moisture trapping layer (B). In the coating layer (C), a moisture permeability at 40°C and 90%RH is $6.0 \times 10^4$ g/m$^2$/day or less, and a storage modulus E' (at $2\pi$ rad/s) in viscoelasticity measurement at 85°C is 30 MPa or more.

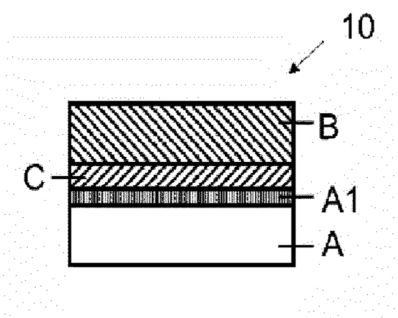


FIG. 1

EP 4 151 402 A1

## Description

### Technical Field

The present invention relates to a moisture barrier laminated film including an inorganic barrier layer and a moisture trapping layer, and particularly relates to a moisture barrier laminated film exhibiting high moisture barrier properties even in a high humidity atmosphere.

### Background Art

As a means for improving properties of various plastic substrates, particularly gas barrier properties, it has been known to form an inorganic thin film (inorganic barrier layer) made of silicon oxide or the like on a surface of a plastic substrate by vapor deposition (Patent Document 1), and a film including such an inorganic thin film has been widely used as a barrier film.

Various electronic devices that have been developed and put to practical use in recent years, for example, organic electroluminescence (organic EL), a solar cell, a touch panel, an electronic paper, and the like are also required to have high moisture barrier properties. In order to satisfy such requirements, the present applicant has proposed a moisture barrier laminate having a structure in which a moisture trapping layer is laminated (Patent Document 2).

The moisture trapping layer as described above is formed by applying a coating composition for forming a moisture trapping layer onto an inorganic barrier layer formed on a surface of a plastic film by vapor deposition or the like and curing the coating composition.

The moisture barrier laminate disclosed in Patent Document 2 exhibits excellent moisture barrier properties, and is used as a sealing material for an electronic device such as an organic EL.

Recently, the degree of moisture barrier properties required has been increased with the improvement in performance of various electronic devices. Therefore, it is necessary to confirm whether the moisture barrier laminated film used as a sealing material has high moisture barrier properties that can satisfy such a requirement. Such a quality test is performed by promoting deterioration in a high-temperature and high-humidity atmosphere at a considerably higher level than a normal humidity atmosphere in which the electronic device is used.

However, the known moisture barrier laminated film has a problem: when the moisture barrier properties are measured in a high humidity environment, particularly in a high-temperature and high-humidity atmosphere such as a deterioration promoting test, the interlayer adhesion and the moisture barrier properties decrease significantly. Further improvement is required.

### Citation List

#### Patent Literature

Patent Document 1: JP 2000-255579 A
Patent Document 2: JP 2015-96320 A

### Summary of Invention

#### Technical Problem

Accordingly, an object of the present invention is to provide a moisture barrier laminated film including a plastic film (A) having an inorganic barrier layer (A1) on a surface thereof and a moisture trapping layer (B), in which excellent moisture barrier properties are exhibited for a long period even in a high-temperature and high-humidity atmosphere.

#### Solution to Problem

As for a moisture barrier laminated film having excellent moisture barrier properties in a high-temperature and high-humidity atmosphere, the present applicant has previously proposed, in JP 2020-183064 A (Japanese Patent Application No. 2019-087677), a moisture barrier laminated film that includes a plastic film (A) having an inorganic barrier layer (A1), an alkaline component-containing moisture trapping layer (B), and a coating layer (C) provided between the inorganic barrier layer (A1) and the moisture trapping layer (B). The coating layer (C) is formed of a polymer having a moisture permeability at 40°C and 90%RH of $6.0 \times 10^4$ g/m$^2$/day or less. This film is used for a deterioration promoting

test in a high-temperature and high-humidity atmosphere at 85°C or higher and relative humidity of 85% or more.

That is, in the moisture barrier laminated film, by providing a coating layer (C) made of a non-aqueous polymer in which the moisture permeability at 40°C and 90%RH of $6.0 \times 10^4$ g/m$^2$/day or less between the alkaline component-containing moisture trapping layer (B) and the inorganic barrier layer (A1), the barrier properties of the moisture trapping layer (B) and the inorganic barrier layer (A1) are sufficiently exhibited, and excellent moisture barrier properties are exhibited even in a high-temperature and high-humidity atmosphere of 85°C or higher and a relative humidity of 85% or higher.

The present inventors have pushed forward the technology of the above application (Japanese Patent Application No. 2019-087677; JP 2020-183064 A), and have found that the coating layer (C) provided between the alkaline component-containing moisture trapping layer (B) and the inorganic barrier layer (A1) may have a constant storage modulus E', and thus the deterioration of moisture barrier properties caused by the alkaline component can be reduced over a longer period of time, thereby completing the present invention.

The present invention provides a moisture barrier laminated film including: a plastic film (A) having an inorganic barrier layer (A1); a moisture trapping layer (B) containing an alkali component; and a coating layer (C) provided between the inorganic barrier layer (A1) and the moisture trapping layer (B). In the coating layer (C), a moisture permeability at 40°C and 90%RH is $6.0 \times 10^4$ g/m$^2$/day or less, and a storage modulus E' (at $2\pi$ rad/s) in viscoelasticity measurement at 85°C is 30 MPa or more.

The moisture barrier laminated film of the present invention can suitably employ the following aspects.

(1) The coating layer (C) is formed of a urethane (meth)acrylate polymer.
(2) The coating layer (C) contains a catalyst in a range of 0.02 to 1.0 mass%.
(3) The catalyst is a metal catalyst.
(4) The urethane (meth)acrylate polymer has a high glass transition point of 85°C or higher.
(5) A protective layer (D) is provided between the inorganic barrier layer (A1) and the coating layer (C).
(6) The protective layer (D) contains not only a water-soluble polymer (D1) but also at least one component (D2) selected from the group consisting of:

organoalkoxysilane or hydrolyzate thereof;
metal alkoxide or hydrolyzate thereof; and
phosphorus compound.

(7) The coating layer (C) is also provided on a side of the moisture trapping layer (B) opposite to the inorganic barrier layer (A1).

Such a moisture barrier laminated film of the present invention is suitably used as a sealing material for an electronic device.

Advantageous Effects of Invention

The moisture barrier laminated film of the present invention has a basic structure in which the moisture trapping layer (B) is provided on the inorganic barrier layer (A 1) present in the plastic film (A), and has a significant feature in that the coating layer is provided between the inorganic barrier layer (A1) and the moisture trapping layer (B), and satisfies a moisture permeation condition in which the moisture permeability at 40°C and 90%RH is $6.0 \times 10^4$ g/m$^2$/day or less, and a viscoelasticity condition in which the storage modulus E' (at $2\pi$ rad/s) in the viscoelasticity measurement at 85°C is 30 MPa or more.

That is, the inorganic barrier layer (A1), which is formed by vapor deposition such as a plasma CVD and is formed of an oxide of Al or Si, exhibits reactivity with alkali, and has a property of a low alkaline resistance.

On the other hand, since the moisture trapping layer (B) secures high moisture trapping properties, an ionic polymer is used as the film-forming component, but such an ionic polymer contains an alkaline component in any of the cationic and anionic polymers. For example, the cationic polymer has a cationic group such as a quaternary ammonium group, and thus, contains an amine component. On the other hand, the anionic polymer contains alkali metal salts such as Na salts and K salts, and thus, when the anionic polymer comes into contact with water, alkali such as NaOH and KOH is formed. Furthermore, in the moisture trapping layer (B), a moisture absorbing agent is also blended in order to confine, in the moisture trapping layer (B), moisture that has been absorbed by the ionic polymer and prevent deformation such as swelling due to moisture absorption. The most suitable as such a moisture absorbing agent is a Na salt or a K salt of crosslinked poly(meth)acrylic acid, and an alkali is also formed when the moisture absorbing agent comes into contact with water.

Accordingly, when the moisture trapping layer (B) is formed directly on the inorganic barrier layer (A1), the

moisture trapping layer (B) contains an alkaline component, and thus the inorganic barrier layer (A1) is alkali-deteriorated. In such a case, when the laminated film is held under conditions in a high-temperature and high-humidity atmosphere, the moisture trapping layer (B) in the film absorbs a large amount of moisture in a short period of time. As a result, alkali deterioration of the inorganic barrier layer (A1) is significantly promoted, delamination occurs at an interface between the inorganic barrier layer (A1) and the moisture trapping layer (B) or an interface between the inorganic barrier layer (A1) and the plastic film (A), moisture leaks from this portion, and the moisture barrier properties are greatly impaired. That is, even if extremely high moisture barrier properties are exhibited in a low humidity atmosphere, the moisture barrier properties are greatly reduced in a high-temperature and high-humidity atmosphere. When the actual use environment is not a high-temperature and high-humidity atmosphere, there is another problem: if the deterioration promoting test cannot be performed for the performance evaluation, an inconvenience in quality control occurs.

However, in the present invention, since the coating layer (C) satisfying the moisture permeation condition and the viscoelasticity condition described above is provided between the inorganic barrier layer (A1) and the moisture trapping layer (B), the alkali deterioration of the inorganic barrier layer (A1) due to moisture absorbed by the moisture trapping layer (B) is effectively reduced. For example, high moisture barrier properties can be exhibited even when the inorganic barrier layer (A1) is held in a high-temperature and high-humidity atmosphere for a long time. This enables performing a deterioration promoting test for evaluating the performance of the moisture barrier properties.

Here, the moisture permeation condition and the viscoelasticity condition that should be satisfied by the coating layer (C) will be briefly described.

First, a description is given for the moisture permeation condition, that is, the moisture permeability at 40°C and 90%RH of $6.0 \times 10^4$ g/m$^2$/day or less. This indicates that the coating layer (C) is a film formed of a nonaqueous polymer, specifically, a film formed of a solventbased coating material. Such conditions are those proposed in our previous application (Japanese Patent Application No. 2019-087677). The non-aqueous coating layer (C) provided between the inorganic barrier layer (A1) and the moisture trapping layer (B) reduces, as far as possible, the transition of alkali-containing moisture from the moisture trapping layer (B) to the inorganic barrier layer (A1), and effectively reduces film peeling due to alkali deterioration of the inorganic barrier layer (A1).

Next, a description is given for the viscoelasticity condition, that is, the storage modulus E' (at 2$\pi$ rad/s) in viscoelasticity measurement at 85°C is 30 MPa or more. This is the most important feature of the present invention. That is, the fact that the coating layer (C) exhibits such storage modulus E' means that the coating layer (C) is a viscoelastic body, in other words, when a certain stress is applied, distortion (deformation) occurs with a certain delay. In the present invention, the coating layer (C) made of such a viscoelastic body exhibits a storage modulus E' (at 2$\pi$ rad/s) at a high temperature (85°C) of 30 MPa or more, which is extremely large. Loosening of the coating film at high temperatures is thus reduced, and the coating film is hard to deform against shearing force (that is, hard to peel off) at high temperatures.

Therefore, in the present invention, such coating layer (C) provided between the inorganic barrier layer (A1) and the moisture trapping layer (B) reduces alkali deterioration of the inorganic barrier layer (A1) even in a high-temperature and high-humidity atmosphere. Moreover, the coating layer (C) is in a state of being hardly peeled off even at a high temperature. As a result, permeation of the alkali-containing moisture into the inorganic barrier layer (A1) is reduced even in a high-temperature and high-humidity atmosphere, and high moisture barrier properties are exhibited over a long period of time.

For example, when the coating layer (C) satisfies the moisture permeation condition but does not satisfy the viscoelasticity condition, the peeling strength between the inorganic barrier layer (A1) and the substrate is high (for example, higher than 2 N/15 mm) in an atmosphere of 85°C and 85%RH, but high moisture barrier properties can be exhibited only for about 1 to 3 days. On the other hand, in accordance with the present invention, when both the moisture permeation condition and the viscoelasticity condition described above are satisfied, high peel strength is secured even after 10 days, and even after 20 days, and high moisture barrier properties are exhibited.

Therefore, the moisture barrier laminated film of the present invention exhibits the high moisture barrier properties even when the use environment is a high-temperature and high-humidity atmosphere, and moreover, the deterioration promoting test can be performed for the performance evaluation in a short time.

Brief Description of Drawings

FIG. 1 is a diagram illustrating an example of a layer structure of a moisture barrier laminated film according to an embodiment of the present invention.

FIG. 2 is a diagram illustrating a structure of a moisture trapping layer (B) in the moisture barrier laminated film of FIG. 1.

FIG. 3 is a diagram illustrating another example of the layer structure of the moisture barrier laminated film according to an embodiment of the present invention.

FIG. 4 is a diagram illustrating another example of the layer structure of the moisture barrier laminated film according

to an embodiment of the present invention.

FIG. 5 is a diagram illustrating another example of the layer structure of a moisture barrier laminated film according to an embodiment of the present invention.

## Description of Embodiments

In FIG. 1, a moisture barrier laminated film according to an embodiment of the present invention generally indicated by 10 includes a plastic film (A) as a substrate. An inorganic barrier layer (A1) is formed on a surface of the plastic film (A). A coating layer (C) is provided between the inorganic barrier layer (A1) and a moisture trapping layer (B). That is, the coating layer (C) and the moisture trapping layer (B) are formed in this order on the inorganic barrier layer (A1) of the plastic film (A).

In the plastic film (A), a protective layer (D) may be provided on the inorganic barrier layer (A1) as illustrated in FIG. 3. That is, the coating layer (C) may be directly laminated on the inorganic barrier layer (A1), or may be laminated on the protective layer (D) appropriately provided on the inorganic barrier layer (A1) as illustrated in FIG. 3, and only need be present between the inorganic barrier layer (A1) and the moisture trapping layer (B).

### Plastic Film (A)

The film (A) serves as a base of the inorganic barrier layer (A1), and is usually molded by injection or co-injection molding, extrusion or co-extrusion molding, film or sheet molding, compression molding, cast polymerization, or the like, depending on the form, using a thermoplastic or thermosetting resin.

Typically, a thermoplastic resin is suitable from the perspective of formability, cost, and the like.

Examples of such a thermoplastic resin include, but are not limited to, the following.

Polyolefin:

- low density polyethylene; high density polyethylene; polypropylene;
- poly(1-butene); poly(4-methyl-1-pentene);
- random or block copolymer of $\alpha$-olefins such as ethylene, propylene, 1-butene, and 4-methyl-1-pentene;
- cyclic olefin copolymer, and the like;

Ethylene-vinyl compound copolymer:
ethylene-vinyl acetate copolymer; ethylene-vinyl alcohol copolymer; ethylene-vinyl chloride copolymer, and the like;
Styrene-based resin:

- polystyrene; acrylonitrile-styrene copolymer; ABS;
- $\alpha$-methylstyrene-styrene copolymer, and the like;

Polyvinyl compound:
polyvinyl chloride; polyvinylidene chloride; vinyl chloride-vinylidene chloride copolymer; polymethylacrylate; polymethyl methacrylate, and the like;
Polyamide:

- Nylon 6; Nylon 6-6; Nylon 6-10; Nylon 11;
- Nylon 12 and the like;
- Thermoplastic polyester:
  - polyethylene terephthalate (PET); polybutylene terephthalate;
  - polyethylene naphthalate (PEN) and the like;

Polycarbonate:
Polyphenylene oxide:
Other resins:

- polyimide resin; polyamideimide resin; polyetherimide resin;
- fluorine resin; allyl resin; urethane resin; cellulose resin;
- polysulfone resin; polyethersulfone resin; ketone resin; and
- amino resin; biodegradable resin such as polylactic acid.

In addition, it may be a blend of various resins exemplified above, or a resin obtained by appropriately modifying any of these resins by copolymerization (for example, an acid-modified olefin resin or the like).

The plastic film (A) is also suitably formed of a gas barrier resin or the like having excellent oxygen barrier properties such as an ethylene-vinyl alcohol copolymer, and may have a multilayer structure including a layer formed of such a gas barrier resin.

In the present invention, it is more suitable to use a polyester resin typified by polyethylene terephthalate (PET) or an olefin resin typified by polyethylene or polypropylene as the plastic film (A) from the viewpoint of easy availability, cost, mold ability, or slight barrier properties to oxygen, and further from the viewpoint of being suitable as a base of the inorganic barrier layer (A1) to be described below.

The thickness of such a plastic film (A) is not particularly limited, and it is sufficient that the plastic film (A) has an appropriate thickness according to the application.

Inorganic Barrier Layer (A1)

The inorganic barrier layer (A1) provided on the surface of the plastic film (A) may be a known film disclosed by, for example, JP 2015-96320 A or the like. An inorganic vapor deposition film formed by techniques such as physical vapor deposition typified by sputtering, vacuum vapor deposition, ion plating, or the like, and chemical vapor deposition typified by plasma CVD, or the like, for example, a film formed of various metals or metal oxides is suitable for the inorganic barrier layer in that high oxygen barrier properties can be secured. In particular, from the viewpoint that a film is uniformly formed on a surface having irregularities and excellent barrier properties against not only oxygen but also moisture are exhibited, it is preferable that plasma CVD is applied to form the inorganic barrier layer on the plastic film (A) serving as a base.

The vapor deposition film formed by plasma CVD is obtained by: disposing the plastic film (A) serving as a base of the inorganic barrier layer (A1) in a plasma treatment chamber held at a predetermined vacuum degree; supplying a gas (reaction gas) of a metal forming a film or a compound containing the metal and an oxidizing gas (usually a gas of oxygen or NOx), together with a carrier gas such as argon or helium if appropriate, to the plasma treatment chamber shielded by a metal wall and decompressed to a predetermined vacuum degree by using a gas supply tube; generating glow discharge by a microwave electric field or a high-frequency electric field in this state; generating plasma by electric energy of the generated glow discharge; and depositing a decomposition reaction product of the compound on the surface of the plastic film A to form a film.

As the reaction gas, a gas of an organoaluminum compound is used in general, from the viewpoint that the organoaluminum compound can form a film having a flexible region containing a carbon component at the interface with the film (A) that is a base, and having a region having a high degree of oxidation and excellent barrier properties on the flexible region. Examples of the organometallic compound include an organoaluminum compound such as trialkylaluminum, an organotitanium compound, an organozirconium compound, and an organosilicon compound. The inorganic barrier layer (A1) is formed in the form of a metal oxide.

The inorganic barrier layer (A1) can also be formed on the plastic film (A) by coating or the like without using a technique such as vapor deposition. That is, the inorganic barrier layer (A1) formed by coating has lower characteristics such as oxygen barrier properties than those formed by the above-described vapor deposition or the like, but may be formed by coating depending on the required degree of barrier properties to oxygen or the like.

Typical examples of the inorganic barrier layer (A1) formed by coating include those obtained by applying, to a predetermined surface, an organic solvent solution containing polysilazane, a polycondensable silane compound (for example, alkoxysilane and the like), and a polycondensable alumina compound (for example, alkoxyaluminum and the like) as a film-forming component with inorganic fine particles such as silica and alumina being appropriately mixed, heating, and volatilizing the organic solvent to form a film.

The thickness of the inorganic barrier layer (A1) described above varies depending on the use of the moisture barrier laminated film and the required level of barrier properties, but in general, it is preferable to set the thickness so that the characteristics of the plastic film (A) and the like serving as a base in vapor deposition are not impaired, and a water vapor permeability of $10^{-1}$ g/m$^2$·day/atom or less, particularly $10^{-2}$ g/m$^2$·day/atom or less can be secured. Specifically, the thickness may be generally about 4 to 500 nm, particularly about 30 to 400 nm, although it varies depending on the proportion occupied by the high oxidation degree region described above.

In particular, the inorganic barrier layer (A1) formed of aluminum oxide or silicon oxide exhibits the highest barrier properties against oxygen, and thus is most suitable in the present invention.

Moisture Trapping Layer (B)

The moisture trapping layer (B) blocks moisture flowing in the thickness direction of the moisture barrier laminated film 10, and contains an ionic polymer as a film-forming component (that is, matrix) particularly from the viewpoint

of exhibiting a high trapping property with respect to moisture. In addition, most suitably, the moisture trapping layer (B) has a structure in which an ionic polymer is used as a matrix, and a moisture absorbing agent having a lower ultimate humidity than that of the ionic polymer is dispersed in the matrix. Such a moisture absorbing agent has a function of confining moisture captured by the ionic polymer, and by dispersing such a moisture absorbing agent, deformation such as swelling caused by moisture absorption can be effectively avoided.

Ionic Polymer

Examples of the ionic polymer used in the present invention include the following cationic polymers and anionic polymers.

The cationic polymer is a polymer having, in the molecule, a cationic group that can be positively charged in water, for example, primary to tertiary amino groups, a quaternary ammonium group, a pyridyl group, an imidazole group, a quaternary pyridinium, or the like. Such a cationic polymer can form a matrix having hygroscopicity because the cationic group has a strong nucleophilic action and supplements water by hydrogen bonding.

The amount of the cationic group in the cationic polymer may be generally such an amount that the water absorption rate (JIS K-7209-1984) of the hygroscopic matrix to be formed is 5% or more, particularly 30% to 45% under an atmosphere of a humidity of 80%RH and 30°C.

Usable examples of the cationic polymer include those obtained by polymerizing or copolymerizing at least one of cationic monomers represented by: amine-based monomers such as allylamine, ethyleneimine, vinylbenzyltrimethylamine, [4-(4-vinylphenyl)-methyl]-trimethylamine, and vinylbenzyltriethylamine; nitrogen-containing heterocyclic monomers such as vinylpyridine and vinylimidazole; and salts thereof, together with another copolymerizable monomer if appropriate; and as necessary, partially neutralizing the polymerized or copolymerized product by acid treatment.

Such a cationic polymer is described in detail in JP 2015-96320 A and the like, and details thereof are omitted, but polyallylamine is generally suitable for this cationic polymer from the viewpoint of film formability and the like.

On the other hand, the anionic polymer is a polymer having an anionic functional group that can be negatively charged in water, for example, a carboxylic acid group, a sulfonic acid group, a phosphonic acid group, or an acidic base in which these groups are partially neutralized, in the molecule. The anionic polymer having such a functional group can form a hygroscopic matrix because the functional group supplements water by hydrogen bonding.

The amount of the anionic functional group in the anionic polymer varies depending on the type of functional group, but as with the cationic polymer described above, may be generally such an amount that the water absorption rate (JIS K-7209-1984) of the hygroscopic matrix to be formed is 5% or more, particularly 30% to 45% under an atmosphere of a humidity of 80%RH and 30°C.

Usable examples of the anionic polymer having a functional group as described above include those obtained by polymerizing or copolymerizing at least one of anionic monomers represented by: carboxylic acid monomers such as methacrylic acid, acrylic acid, and maleic anhydride; sulfonic acid-based monomers such as $\alpha$-halogenated vinyl sulfonic acid, styrene sulfonic acid, and vinyl sulfonic acid; phosphonic acid-based monomer such as vinyl phosphoric acid; and salts of these monomers, together with another copolymerizable monomer if appropriate, and as necessary, partially neutralizing the polymerized or copolymerized product by alkali treatment.

Such an anionic polymer is also described in detail in JP 2015-96320 A and the like, and details thereof are omitted, but generally, poly(meth)acrylic acid and partially neutralized products thereof (for example, partly Na salt) are described.

Structure of Moisture Trapping Layer (B)

Referring to FIG. 2(a) or 2(b), it is suitable that a moisture absorbing agent having a lower ultimate humidity than that of the ionic polymer (cationic or anionic polymer) forming the matrix is blended in the moisture trapping layer (B).

By dispersing the moisture absorbing agent having hygroscopicity higher than that of the matrix in this manner, moisture absorbed by the matrix formed of the ionic polymer described above is immediately captured by the moisture absorbing agent, and the absorbed moisture is effectively confined in the matrix. Thus, not only the moisture absorbing ability of moisture can be effectively exhibited even in an extremely low humidity atmosphere, but also swelling of the moisture trapping layer (B) due to absorption of moisture is effectively reduced.

Suitable usable examples of the highly hygroscopic moisture absorbing agent as described above include those having the ultimate humidity lower than that of the ionic polymer, for example, a moisture absorbing agent having an ultimate humidity of 6% or less under environmental conditions of a humidity of 80%RH and a temperature of 30°C. That is, when the ultimate humidity of the moisture absorbing agent is higher than that of the ionic polymer, moisture absorbed in the matrix is not sufficiently confined, and moisture is easily released, so that significant improvement in the moisture barrier properties cannot be expected. In addition, even when the ultimate humidity is lower than that of the ionic polymer, if the ultimate humidity measured under the above conditions is higher than the above range, for example, trapping of

moisture in a low-humidity atmosphere becomes insufficient, and the moisture barrier properties may not be sufficiently exhibited.

The moisture absorbing agent as described above generally has a water absorption rate (JIS K-7209-1984) of 50% or more in an atmosphere with a humidity of 80%RH and a temperature of 30°C, and examples thereof include inorganic and organic moisture absorbing agents.

Examples of the inorganic moisture absorbing agent include zeolite, alumina, activated carbon, clay minerals such as montmorillonite, silica gel, calcium oxide, and magnesium sulfate.

Examples of the organic moisture absorbing agent include a crosslinked product of an anionic polymer or a partially neutralized product thereof. Examples of the anionic polymer include those obtained by polymerizing or copolymerizing at least one of anionic monomers represented by carboxylic acid-based monomers ((meth)acrylic acid, maleic anhydride, and the like), sulfonic acid-based monomers (halogenated vinylsulfonic acid, styrenesulfonic acid, vinylsulfonic acid, and the like), phosphonic acid-based monomers (vinyl phosphoric acid, and the like), salts of these monomers, and the like, together with another monomer. In particular, in applications where transparency is required, the organic moisture absorbing agent is effective. For example, fine particles of crosslinked sodium poly(meth)acrylate or crosslinked potassium poly(meth)acrylate are typical organic moisture absorbing agents.

In the present invention, a moisture absorbing agent having a small particle size is preferable (for example, average primary particle size is 100 nm or less, particularly 80 nm or less) from the viewpoint of increasing the specific surface area and exhibiting high hygroscopicity, and a moisture absorbing agent of an organic polymer having a small particle size is particularly optimal.

The moisture absorbing agent of the organic polymer has very excellent dispersibility in the matrix of the ionic polymer, and can be uniformly dispersed. Furthermore, when emulsion polymerization, suspension polymerization, or the like is employed as a polymerization method for producing the moisture absorbing agent, particles can have a fine and uniform spherical shape. Blending the moisture absorbing agent of the organic polymer to some extent or more enables very high transparency to be secured.

In addition, in the case of the organic fine moisture absorbing agent, the above-described ultimate humidity is remarkably low, and not only high hygroscopicity is exhibited, but also a volume change due to swelling can be extremely reduced by crosslinking. And thus, the organic fine moisture absorbing agent is optimal in reducing the humidity to an absolute dry state or a state close to the absolute dry state while reducing the volume change.

Examples of fine particles of such an organic moisture absorbing agent include crosslinked sodium polyacrylate fine particles (average particle diameter: about 70 nm), commercially available in the form of a colloidal dispersion (pH = 10.4) from Toyobo Co., Ltd. under the trade name of TAFTIC HU-820E.

In the present invention, in particular, in an application in which super moisture barrier properties are required, the above-described moisture trapping layer (B) is set to have a thickness (for example, 1 μm or more, particularly about 2 to 20 μm) at which the super barrier properties are exhibited so that the water vapor permeability is $10^{-5}$ g/$m^2$/day or less.

In addition, the amount of the moisture absorbing agent is set according to the type of the ionic polymer from the viewpoint of sufficiently exhibiting the properties, significantly improving the moisture barrier properties, effectively reducing the dimensional change due to swelling, and securing the moisture barrier properties higher than the barrier properties exhibited by the inorganic barrier layer (A1) over a long period of time. For example, when the matrix is formed of a cationic polymer, the moisture absorbing agent is preferably present in an amount of 50 parts by mass or more, particularly 100 to 900 parts by mass, and more preferably 200 to 600 parts by mass, based on 100 parts by mass of the ionic polymer in the moisture trapping layer (B). Further, when the matrix is formed of an anionic polymer, the moisture absorbing agent is preferably present in an amount of 50 parts by mass or more, particularly 100 to 1300 parts by mass, and more preferably 150 to 1200 parts by mass, based on 100 parts by mass of the anionic polymer in the moisture trapping layer (B).

In the moisture trapping layer (B) having the structure as described above, it is suitable that a crosslinked structure is introduced into the ionic polymer. When a crosslinked structure is introduced into the ionic polymer, molecules of the cationic polymer are constrained to each other by crosslinking when water is absorbed, and a volume change due to swelling (moisture absorption) is reduced, leading to improvement of mechanical strength and dimensional stability.

Such a crosslinked structure can be introduced by blending a crosslinking agent in the coating composition for forming the moisture trapping layer (B). In particular, in the case of the anionic polymer, unlike the cationic polymer, only water is supplemented by hydrogen bonding. Therefore, by introducing a network structure (crosslinked structure) of spaces suitable for moisture absorption into the matrix, the hygroscopicity can be greatly enhanced.

The crosslinking agent for introducing such a crosslinked structure is slightly different between the case of introducing a crosslinked structure into the cationic polymer and the case of introducing a crosslinked structure into the anionic polymer.

Usable examples of the crosslinking agent for the cationic polymer include a compound having a crosslinkable functional group (for example, epoxy groups) capable of reacting with a cationic group and a functional group (for example, alkoxysilyl groups) capable of forming a siloxane structure in a crosslinked structure through hydrolysis and

dehydration condensation, particularly, a silane compound represented by Formula (1):

$$X\text{-}SiR^1_n(OR^2)_{3-n} \ldots \qquad (1)$$

wherein X is an organic group having an epoxy group at a terminal,

$R^1$ and $R^2$ are each a methyl group, an ethyl group, or an isopropyl group, and
n is 0, 1, or 2.

Such a silane compound has an epoxy group and an alkoxysilyl group as functional groups, and the epoxy group undergoes an addition reaction with the functional group (for example, $NH_2$) of the cationic polymer. On the other hand, the alkoxysilyl group generates a silanol group (SiOH group) by hydrolysis, forms a siloxane structure through a condensation reaction, and grows to finally form a crosslinked structure between cationic polymer chains. As a result, a crosslinked structure having a siloxane structure is introduced into the matrix of the cationic polymer.

Moreover, the cationic polymer is alkaline, and as a result, when the coating composition containing the cationic polymer is applied to form the moisture trapping layer B, the addition reaction between the cationic group and the epoxy group and the dehydration condensation between the silanol groups are also rapidly promoted, and the crosslinked structure can be easily introduced.

In the present invention, as the organic group X having an epoxy group in Formula (1), a γ-glycidoxyalkyl group is representative, and for example, γ-glycidoxypropyltrimethoxysilane or γ-glycidoxypropylmethyldimethoxysilane is suitably used as a crosslinking agent.

In addition, those in which the epoxy group in Formula (1) is an alicyclic epoxy group such as an epoxy cyclohexyl group are also suitable as the crosslinking agent. For example, when a compound having an alicyclic epoxy group such as β-(3,4-epoxycyclohexyl) ethyltrimethoxysilane is used as a crosslinking agent, an alicyclic structure is introduced into the crosslinked structure of the matrix together with a siloxane structure. The introduction of such an alicyclic structure can more effectively exhibit the function of the matrix that forms a network structure of spaces suitable for moisture absorption.

Further, in order to introduce an alicyclic structure into the crosslinked structure, a compound having a plurality of epoxy groups and alicyclic groups, for example, a diglycidyl ester represented by Formula (2) can be used as a crosslinking agent:

$$G\text{-}O(C{=}O)\text{-}A\text{-}(C{=}O)O\text{-}G \ldots \qquad (2)$$

where G is a glycidyl group,
A is a divalent hydrocarbon group having an aliphatic ring, for example, a cycloalklene group. Typical examples of such diglycidyl esters are represented by Formula (2-1).

[Chem. 1]

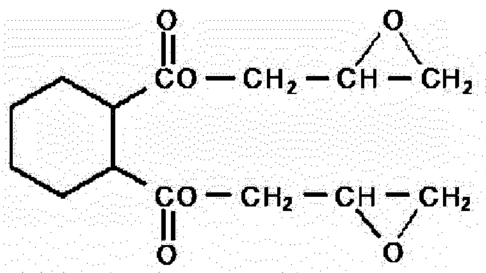

(2-1)

The diglycidyl ester of Formula (2) does not have an alkoxysilyl group, but is effective in that a network structure of spaces suitable for moisture absorption is formed in the matrix because an alicyclic structure is introduced into the crosslinked structure.

It is desirable that the crosslinking agent is used in an amount of 5 to 60 parts by mass, particularly 15 to 50 parts by mass, based on 100 parts by mass of the cationic polymer, and it is desirable that at least 70 mass% or more,

preferably 80 mass% or more of such a crosslinking agent is the silane compound of Formula (1) described above.

On the other hand, as the crosslinking agent for introducing a crosslinked structure into the anionic polymer, a compound having two or more crosslinkable functional groups (for example, epoxy groups) capable of reacting with the ionic groups possessed by the anionic polymer can be used, and diglycidyl ester represented by Formula (2), which is also exemplified in the coating composition for a cationic matrix, is suitably used:

G-O(C=O)-A-(C=O)O-G ... (2)

where G is a glycidyl group,
A is a divalent hydrocarbon group having an aliphatic ring, for example, cycloalkylene group.

In the diglycidyl ester of Formula (2), the epoxy group reacts with the anionic group, and a crosslinked structure including an alicyclic structure by the divalent group A is formed in the matrix. The crosslinked structure including such an alicyclic structure brings about reduction of swelling.

In particular, preferred diglycidyl esters among the above diglycidyl esters have been mentioned above, and in particular, from the viewpoint that a network structure of spaces suitable for moisture absorption can be formed, the diglycidyl ester represented by Formula (2-1) is most preferred.

Such a crosslinking agent for the anionic polymer is desirably used in an amount of 1 to 50 parts by mass, particularly 10 to 40 parts by mass, based on 100 parts by mass of the anionic polymer.

Formation of Moisture Trapping Layer (B)

In addition, the above-described moisture trapping layer (B) is formed by using a coating composition in which a moisture absorbing agent and, if necessary, a crosslinking agent are dissolved or dispersed in a predetermined solvent in a resin serving as a matrix, applying the coating composition onto a coating layer (C) formed on an inorganic barrier layer (A1) to be described below, and removing the solvent by heating and drying. Such heating and drying are usually performed at a temperature of about 100 to 170°C for 3 minutes or shorter, particularly in a short time of about 0.25 to 1 minute, whereby the moisture trapping layer (B) firmly adhering to the inorganic barrier layer (A1) can be formed via the coating layer (C).

In the coating composition to be used for formation of the moisture trapping layer (B) as described above, the solvent is not particularly limited as long as it can be volatilized and removed by heating at a relatively low temperature, and usable examples of the solvent include an alcoholic solvent such as methanol, ethanol, propyl alcohol or butanol, a ketone solvent such as acetone or methyl ethyl ketone, a mixed solvent of these solvents and water, or an aromatic hydrocarbon-based solvent such as benzene, toluene or xylene.

When a silane compound is blended as a crosslinking agent, it is desirable to use water or a mixed solvent containing water in order to promote hydrolysis of the silane compound. Furthermore, in the case of forming the moisture trapping layer (B) containing an anionic polymer, it is desirable that the pH is adjusted to about 8 to 12 by adding alkali (for example, sodium hydroxide).

The solvent described above is used in such an amount that the coating composition has a viscosity suitable for coating, but a nonionic polymer can also be blended in an appropriate amount in order to adjust the viscosity of the coating composition or to adjust the water absorption rate of the hygroscopic matrix to be formed to an appropriate range.

Examples of such a nonionic polymer include saturated aliphatic hydrocarbon-based polymers such as polyvinyl alcohol, an ethylene-propylene copolymer, and polybutylene; a styrene-based polymer such as a styrene-butadiene copolymer; a chlorine-based polymer such as polyvinyl chloride; or those obtained by copolymerizing these polymers with various comonomers. Typical examples of the comonomer include styrene-based monomers such as vinyltoluene, vinylxylene, chlorostyrene, chloromethylstyrene, $\alpha$-methylstyrene, $\alpha$-halogenated styrene, $\alpha,\beta,\beta'$-trihalogenated styrene, monoolefins such as ethylene and butylene, and conjugated diolefins such as butadiene and isoprene.

In the present invention, as the moisture trapping layer (B) described above, a layer containing a cationic polymer as a matrix (film-forming component) is particularly suitable. Those having such a cationic polymer need to be heated at a high temperature of 100°C or higher for a long time in order to secure particularly high adhesion. But in the present invention, there is also an advantage: when the coating layer (C) described below is provided as a base, the moisture trapping layer (B) that firmly adheres and is held can be formed without heating at such a high temperature for a long time.

Coating Layer (C)

As already mentioned, in the present invention, it is essential to provide the coating layer (C) between the inorganic barrier layer (A1) and the moisture trapping layer (B).

The moisture trapping layer (B) used for securing high moisture barrier properties contains an alkali component.

That is, when a cationic polymer is used as a film-forming component (matrix), an alkali such as an amine is contained in the layer. This is because an amine-based compound is used in the cationic polymer in order to introduce a cationic group such as an amino group into the polymer, and thus such an amine-based compound is contained as an inevitable component. In addition, the anionic polymer contains an alkali base of a carboxylic acid, and when moisture is captured, alkali such as NaOH or KOH is generated. Furthermore, even when crosslinked sodium polyacrylate or the like most suitable as a moisture absorbing agent is used, alkali such as NaOH or KOH is generated by trapping moisture.

On the other hand, since the inorganic barrier layer (A1) exhibits reactivity with alkali, alkali resistance is extremely poor. When the moisture trapping layer (B) is directly provided on the inorganic barrier layer (A1), the inorganic barrier layer (A1) reacts with the alkali contained in the moisture trapping layer (B). As a result, delamination occurs between the moisture trapping layer (B) and the inorganic barrier layer (A1) or at an interface between the inorganic barrier layer (A1) and the plastic film (A). Therefore, when such a moisture barrier laminated film is held in a high-temperature and high-humidity atmosphere having a temperature of 85°C or higher and a relative humidity RH of 85% or higher and subjected to a deterioration promoting test, film peeling occurs in a short time, and the moisture barrier properties are significantly deteriorated.

Therefore, in the present invention, the coating layer (C) is interposed between the inorganic barrier layer (A1) and the moisture trapping layer (B).

In the present invention, as described above, such a coating layer (C) has to satisfy the moisture permeation condition that the moisture permeability at 40°C and 90%RH is $6.0 \times 10^4$ g/m$^2$/day or less and the viscoelasticity condition that the storage modulus E' (at $2\pi$ rad/s) in the viscoelasticity measurement at 85°C is 30 MPa or more.

That is, when the coating layer (C) satisfies the moisture permeation condition described above, migration of the alkali-containing moisture contained in the moisture trapping layer (B) to the inorganic barrier layer (A1) is prevented, and deterioration of the inorganic barrier layer (A1) due to alkali can be avoided. In particular, in order to prevent the transfer of the alkali-containing moisture to the inorganic barrier layer (A1), the above-mentioned moisture permeability is preferably smaller, and for example, the moisture permeability at 40°C and 90%RH is desirably $5.0 \times 10^4$ g/m$^2$/day or less.

In addition, in the present invention, when the coating layer (C) satisfies the viscoelasticity condition described above, loosening of the molecules of the coating layer (C) at a high temperature is reduced, so that deformation of the coating layer (C) against shear force is effectively prevented, and migration of alkali-containing moisture to the inorganic barrier layer (A1) is more reliably reduced even at a high temperature.

As a result, film peeling due to alkali deterioration of the inorganic barrier layer (A1) is reliably prevented, and excellent moisture barrier properties can be exhibited over a long period of time even in a high-temperature and high-humidity atmosphere. In particular, the higher the storage modulus E' (at $2\pi$ rad/s), the higher the effect of reducing the loosening of the molecule of the coating layer (C), and the high moisture barrier properties are exhibited over a longer period of time. For example, the storage modulus E' (at $2\pi$ rad/s) at 85°C is preferably 20 MPa or more, and optimally 30 MPa or more. When the storage modulus E' is excessively large, the film formability may be impaired. Therefore, the storage modulus E' is desirably 1000 MPa or less.

The storage modulus E' depends on a molecular weight between crosslinking points Mc of the molecule of the cured polymer, and for example, in a polymer having the storage modulus E' as described above, the molecular weight between crosslinking points Mc is generally in the range of 5000 g/mol or less. Such a molecular weight between crosslinking points Mc is calculated using a rubber elasticity equation from the value of the storage modulus E' calculated from the viscoelasticity measurement at 85°C as illustrated in the examples described below.

In the present invention, the coating layer (C) satisfying the above-described moisture permeation condition and the viscoelasticity condition is formed of a nonaqueous polymer (specifically, an isocyanate-based polymer) having low moisture permeability and exhibiting viscoelasticity. For example, the thickness is preferably 0.1 $\mu$m or more, particularly 0.2 $\mu$m or more in order to achieve the above-mentioned moisture permeability. However, if the thickness is excessively large, when the moisture barrier properties are enhanced by multilayering, the thickness becomes larger than necessary. Therefore, the thickness is desirably appropriately thin, for example, 7 $\mu$m or less, particularly 5 $\mu$m or less.

In addition, the coating layer (C) desirably has a water contact angle $\theta$ that is large to some extent. As the water contact angle $\theta$ is larger, the coating film is more hydrophobic, and the migration of moisture absorbed by the moisture trapping layer can be reduced. On the other hand, when the value of the water contact angle is too large, the wettability when applying the moisture trapping layer on the coating layer (C) may be negatively affected. Therefore, the value is more preferably in the range of 65 to 100°, particularly 75 to 95°.

In order to achieve the water contact angle, the value of a solubility parameter (SP value) of a base resin to be reacted with isocyanate as a component for forming the coating layer (C) is more preferably in the range of 8.5 to 10.9, particularly 8.6 to 10.7°.

Furthermore, the coating layer (C) desirably has a high glass transition point Tg in terms of further reducing moisture permeation in a high-temperature environment such as a promoting test environment.

That is, as the glass transition point Tg is higher, the mobility of the polymer at a high temperature is reduced, and migration of moisture absorbed by the moisture trapping layer can be reduced. For example, the glass transition point of the coating layer (C) is optimally 85°C or higher. The moisture barrier laminated film of the present invention provided with such a coating layer (C) exhibits excellent moisture barrier properties even in a deterioration promoting test in which the film is held in a high-temperature and high-humidity atmosphere having a temperature of 85°C or higher and a relative humidity RH of 85% or higher. The performance evaluation can be performed quickly and reliably.

In the present invention, the coating layer (C) having such characteristics is, as described briefly above, one formed of an isocyanate-based polymer obtained using isocyanate as a reaction component, for example, one obtained by curing an isocyanate-reactive resin (base resin) with polyisocyanate (curing agent). In such a nonaqueous polymer, the isocyanate group present in the polymer exhibits reactivity not only with the MOH group (M is a metal atom such as Al or Si) present on the surface of the inorganic barrier layer (A1) but also with the ionic group in the ionic polymer in the moisture trapping layer (B). This enables high adhesion to the moisture barrier layer (B), so that delamination of the moisture barrier layer (B) can be prevented over a long period of time, and deterioration of the moisture barrier properties can be effectively prevented.

Examples of such an isocyanate-reactive resin (base resin) include a resin having a functional group capable of reacting with isocyanate, for example, a hydroxyl group, a carboxyl group, an amino group, particularly a hydroxyl group or a carboxyl group, specifically, an ester resin, a (meth)acrylic resin, a polycarbonate resin, or polyvinyl alcohol. A urethane resin can also be used as the isocyanate-reactive resin. In the present invention, a (meth)acrylic resin (poly (meth)acrylic acid or poly (meth)acrylic acid ester) is particularly suitable, and in particular, a urethane (meth)acrylate obtained by a reaction of a (meth)acrylic resin and isocyanate is more suitable for formation of the coating layer (C). Furthermore, from the viewpoint that high adhesion to the moisture trapping layer (B) can be secured, a (meth)acrylic resin into which a glycidyl group is introduced is preferably used as a base resin, and in particular, 0.5 to 97 mass% of the (meth)acrylic resin, particularly 0.7 to 97 mass% thereof, is preferably derived from a glycidyl group-containing (meth)acrylate. The adhesion to the moisture trapping layer is secured by the glycidyl group introduced into the (meth)acrylic resin, and when the amount of the glycidyl group is within the above range, a cured product satisfying the viscoelasticity condition can be formed without impairing adhesion by the glycidyl group. Such a glycidyl group-containing (meth)acrylic compound is represented by, for example, Formula (3):

$$CH_2=CH(R)-COO-(CH_2)m-G \ldots \qquad (3)$$

where R is a hydrogen atom or a methyl group,

G is a glycidyl group, and
m is 0 or an integer of 1 or more.

A typical example of the glycidyl group-containing (meth)acrylate is glycidyl (meth)acrylate (in Formula (3), m = 0).

Furthermore, the (meth)acrylic resin preferably has a hydroxyl value (OHV) of 10 mg KOH or more, more preferably 10 to 150 mg KOH in order for the cured product to satisfy a predetermined viscoelasticity condition. By appropriately containing the (meth)acrylic resin having a hydroxyl group, a viscoelastic body having a network structure satisfying the predetermined viscoelasticity condition is formed by a reaction with an isocyanate compound described below.

As the monomer used for forming the (meth)acrylic resin exhibiting a hydroxyl value as described above, a hydroxyl group-containing (meth)acrylate is used. Examples of such a hydroxyl group-containing (meth)acrylate include the following:

2-hydroxymethyl (meth)acrylate;
2-hydroxypropyl (meth)acrylate;
3-hydroxypropyl (meth)acrylate;
2,3-dihydroxypropyl (meth)acrylate;
2,4-dihydroxypropyl (meth)acrylate;
2-hydroxymethyl-3-hydroxypropyl (meth)acrylate;
2-hydroxybutyl (meth)acrylate;
4-hydroxybutyl (meth)acrylate;
5-hydroxypentyl (meth)acrylate;
diethylene glycol mono(meth)acrylate;
triethylene glycol mono(meth)acrylate;
tetraethylene glycol mono(meth)acrylate;

pentaethylene glycol mono(meth)acrylate; and
2-hydroxypropyl (meth)acrylate.

Also, the following di(meth)acrylates may be used:

ethylene glycol di(meth)acrylate;
triethylene glycol di(meth)acrylate;
butylene glycol di(meth)acrylate;
neopentyl glycol di(meth)acrylate;
propylene glycol di(meth)acrylate;
1,3-butanediol di(meth)acrylate;
1,4-butanediol di(meth)acrylate; and
1,6-hexanediol di(meth)acrylate.

In addition to the di(meth)acrylate, tri(meth)acrylate such as trimethylolpropane tri(meth)acrylate can also be used.

As long as the glycidyl group content and the hydroxyl value content described above are satisfied, the (meth)acrylic resin may contain a monomer used for forming an ordinary (meth)acrylic resin, for example, a polymer formed from methyl (meth)acrylate, ethyl (meth)acrylate, propyl (meth)acrylate, isopropyl (meth)acrylate, butyl (meth)acrylate, t-butyl (meth)acrylate, pentyl (meth)acrylate, hexyl (meth)acrylate, cyclohexyl (meth)acrylate, styrene, or the like.

Furthermore, from the viewpoint of increasing the glass transition point Tg of the coating layer (C), the isocyanate-reactive resin, particularly the (meth)acrylic resin desirably has a glass transition point Tg of 60°C or higher, more preferably 65°C or higher, and still more preferably 70°C or higher. In addition, the weight average molecular weight (Mw) is desirably 10000 or more, more preferably 15000 or more, and still more preferably 20000 or more.

Usable examples of the isocyanate (that is, the curing agent) to be reacted with the isocyanate-reactive resin include, but not limited thereto, polyisocyanates having two or more isocyanate groups, for example, diisocyanates such as aromatic diisocyanate, araliphatic diisocyanate, alicyclic diisocyanate, and aliphatic diisocyanate, and these can be used alone or in combination of two or more, and further tri- or higher functional polyisocyanates can be used in combination.

Examples of the aromatic diisocyanate include the following compounds:

m- or p-phenylene diisocyanate or mixtures thereof;
4,4’-diphenyldiisocyanate, 1,5-naphthalene diisocyanate (NDI), 4,4’-, 2,4’- or 2,2’-diphenylmethane diisocyanate or mixtures thereof (MDI);
2,4- or 2,6-tolylene diisocyanate or mixtures thereof (TDI);
4,4’-toluidine diisocyanate (TODI); and
4,4’-diphenyl ether diisocyanate.

Examples of the araliphatic diisocyanate include:

1,3- or 1,4-xylylene diisocyanate or mixtures thereof (XDI);
1,3- or 1,4-tetramethylxylylene diisocyanate or mixtures thereof (TMXDI); and
co,co’-diisocyanate-1,4-diethylbenzene.

Examples of the alicyclic diisocyanate include:

1,3-cyclopentene diisocyanate;
1,4-cyclohexanediisocyanate;
1,3 -cyclohexanediisocyanate;
3-isocyanatomethyl-3,5,5-trimethylcyclohexyl isocyanate (isophorone diisocyanate; IPDI);
4,4’-, 2,4’- or 2,2’-dicyclohexylmethane diisocyanate or mixtures thereof (hydrogenated MDI);
methyl-2,4-cyclohexanediisocyanate;
methyl-2,6-cyclohexanediisocyanate; and
1,3- or 1,4-bis(isocyanatomethyl) cyclohexane or mixtures thereof (hydrogenated XDI).

Examples of the aliphatic diisocyanate include:

trimethylene diisocyanate;

tetramethylene diisocyanate;
hexamethylene diisocyanate (HDI);
pentamethylene diisocyanate;
1,2-propylene diisocyanate;
1,2-, 2,3- or 1,3-butylene diisocyanate;
2,4,4- or 2,2,4-trimethylhexamethylene diisocyanate; and
2,6-diisocyanate methyl capate.

In the present invention, among the isocyanate compounds described above, diphenylmethane diisocyanate (MDI), tolylene diisocyanate (TDI), hexamethylene diisocyanate (HDI), meta-xylylene diisocyanate, tetramethylene diisocyanate, pentamethylene diisocyanate, lysine isocyanate, isophorone diisocyanate (IPDI), polynuclear condensates of these isocyanates, and the like are suitable. In addition, polyisocyanate in which 1 mass% or more of the total amount of the isocyanate compounds has a weight average molecular weight in the range of 400 to 1200 is advantageous for forming a cured product having, for example, an average molecular weight between crosslinking points in a predetermined range.

Formation of Coating Layer (C)

The coating layer (C) described above can be formed by applying, onto the inorganic barrier layer (A1), a coating composition in which the isocyanate-reactive resin and the isocyanate compound (curing agent) are dissolved or dispersed in a solvent, heating the coating composition to a temperature of 100°C or higher, and baking the coating composition.

Usable examples of the solvent used for forming the coating composition include organic solvents a temperature of which is not higher than necessary when heated for solvent volatilization, such as an alcohol-based organic solvent, a dialkyl glycol ether-based solvent, an ethylene glycol ether-based solvent, a propylene glycol ether-based solvent, an ester-based solvent, a ketone-based solvent, an ether-based solvent, and a hydrocarbon-based solvent.

These solvents are used in amounts such that the coating composition has a viscosity suitable for coating.

As described above, the polymer that forms the coating layer (C) needs to be nonaqueous in order to satisfy certain moisture permeation condition, and therefore, it is not possible to prepare a coating composition using water or a mixed solvent of water and an organic solvent. This is because, when dispersed in an aqueous solvent, the moisture permeability in a high-temperature and high-humidity atmosphere is increased, alkali-containing moisture is supplied to the inorganic barrier layer (A1) through the coating layer (C), alkali deterioration occurs, and the moisture barrier properties and adhesion are greatly reduced due to occurrence of delamination.

In the coating composition described above, the isocyanate-reactive resin and the isocyanate compound to be used are used in combination depending on the type and number of functional groups thereof such that a cured body satisfying the moisture permeation condition and the viscoelasticity condition described above is formed. For example, from the viewpoint of satisfying the moisture permeation condition and the viscoelasticity condition, it is preferable that a (meth)acrylic resin having a hydroxyl value of at least 10 mg KOH/g or more is used in an amount of 1 mass% or more per isocyanate-reactive resin, and it is suitable that 0.5 to 97 mass% of the isocyanate-reactive resin is a glycidyl group-containing (meth)acrylic compound described above.

Furthermore, it is preferable that the isocyanate is contained in an amount of at least 0.4 equivalents or more, particularly 0.6 equivalents or more, based on 1 equivalent of the weight of isocyanate required for reacting a functional group component capable of reacting with isocyanate contained in the isocyanate-reactive resin. If the amount is less than 0.4 equivalents, the number of points of reaction with MOH (M is a metal atom such as Al or Si) present on the surface of the inorganic barrier layer (A1) or the ionic group in the ionic polymer in the moisture trapping layer (B) is reduced, resulting in deterioration of adhesion.

From the viewpoint of accelerating the curing reaction, the coating composition may contain a catalyst. Typical examples of such a catalyst include an amine-based catalyst and a metal catalyst.

Examples of the amine-based catalyst include the following:

1,4-diazabicyclo(2,2,2)octane;
PMDETA;
N,N-dimethylcyclohexylamine;
N-methyldicyclohexylamine;
N,N,N,N-tetramethylpropylenediamine;
N,N,N,N-tetramethylhexamethylene diamine;
N-ethylmorpholine;
N-methylmorpholine;

N,N-dimethylethanolamine; and
N,N-diethylethanolamine;

Examples of the metal catalyst include an organotin compound such as dibutyltin laurate, and an organozinc compound.

These catalysts may be used singly or in combination of two or more kinds thereof. The metal catalyst is particularly suitable.

These catalysts are blended in an amount of 0.02 to 1.0 parts by mass per 100 parts by mass of the total amount of the isocyanate-reactive resin and the isocyanate compound. That is, the coating layer (C) contains the catalyst in a ratio corresponding to this amount.

By containing the catalyst, not only the reaction between the isocyanate-reactive resin and the isocyanate compound in the coating layer (C) but also the reaction between the OH group present in a base layer (for example, the inorganic barrier layer) and the isocyanate compound can be promoted, and the adhesion between the base layer and the coating layer (C) can be further strengthened. For example, even when the production speed is high and a high thermal load cannot be applied to the formation of the coating layer (C) as in actual production, the adhesion between the base layer and the coating layer (C) can be stably maintained.

Furthermore, various blending agents may be added to the coating composition described above as long as the adhesion between the coating layer (C) to be formed and the moisture trapping layer (B) or the inorganic barrier layer (A1) is not impaired.

Examples of such blending agents include layered inorganic compounds, stabilizers (antioxidants, heat stabilizers, ultraviolet absorbers, and the like), plasticizers, antistatic agents, lubricants, antiblocking agents, colorants, fillers, and crystal nucleating agents. Of course, as long as the adhesion described above is not impaired, a small amount of resin, such as an olefin resin, that is not reactive with the isocyanate may be blended.

From the viewpoint of storage stability, the terminal of the polyisocyanate in the coating composition may be blocked with a blocking agent. Typical examples of such a blocking agent include: alcohols such as methanol, ethanol, and lactate; phenolic hydroxyl group-containing compounds such as phenol and salicylate; amides such as ε-caprolactam and 2-pyrrolidone; oximes such as acetone oxime and methyl ethyl ketone oxime; active methylene compounds such as methyl acetoacetate, ethyl acetoacetate, acetylacetone, dimethyl malonate, and diethyl malonate. These blocking agents may be used singly or in combination of two or more kinds thereof.

The coating layer (C) formed on the inorganic barrier layer (A1) as described above usually serves as an anchor coat for the moisture trapping layer (B), and the moisture trapping layer (B) is formed on the coating layer (C) as a base.

As illustrated in FIGS. 4 and 5, the coating layer (C) can also be disposed on a side of the moisture trapping layer (B) opposite to the inorganic barrier layer (A1). By adopting such a layer configuration, not only the migration of the alkali component to the inorganic barrier layer (A 1) but also the migration of the alkali component to the opposite side can be reduced.

For example, when another substrate is bonded to the moisture trapping layer (B) with an adhesive layer interposed therebetween by dry lamination, the transfer of an alkali component to the adhesive layer side can also be reduced by providing the coating layer (C) between the moisture trapping layer (B) and the adhesive layer. As a result, the adhesion of the entire laminate can be stably maintained.

Protective Layer (D)

In the present invention, the above-described coating layer (C) only needs to be present between the inorganic barrier layer (A1) and the moisture trapping layer (B). Therefore, as illustrated in FIG. 3, the protective layer (D) may be provided on the inorganic barrier layer (A1), and the above-described coating layer (C) may be provided on the protective layer (D).

The protective layer (D) is for preventing peeling, scratching, breakage, and the like of the inorganic barrier layer (A1) after film formation, and is not particularly limited as long as it is a layer that does not deteriorate the barrier properties of the barrier film under a promoting test environment (under an environment of 85°C and 85%RH), but is generally formed of two or more compounds obtained by blending the component (D1) and the component (D2) shown below.

The component (D1) is a water-soluble polymer, and examples thereof include polyvinyl alcohol, polyvinyl pyrrolidone, starch, methyl cellulose, carboxymethyl cellulose, and sodium alginate. In particular, polyvinyl alcohol is preferable.

The component (D2) is at least one compound selected from the group consisting of an organoalkoxysilane or a hydrolyzate thereof, a metal alkoxide or a hydrolyzate thereof, and a phosphorus compound.

The organoalkoxysilane is, for example, a compound represented by Formula (4):

$R^1\text{-}Si(OR^2)_3$ ... (4)

where $R^1$ is an organic group, and
$R^2$ is an alkyl group.

Examples of the organic group $R^1$ include an alkyl group and a group having various functional groups (for example, a (meth)acryloyl group, a vinyl group, an amino group, an epoxy group, and an isocyanate group).

The alkyl group represented by $R^2$ is not particularly limited, and is generally a lower alkyl group having 4 or less carbon atoms (for example, a methyl group, an ethyl group, a propyl group, and a butyl group).

Examples of such an organoalkoxysilane include the following silane compounds:

ethyltrimethoxysilane;
(meth)acryloxyapropyltrimethoxysilane;
vinyltrimethoxysilane;
glycidoxytrimethoxysilane;
glycidoxypropyltrimethoxysilane;
epoxy cyclohexylethyltrimethoxysilane;
isocyanate propyltrimethoxysilane; and
a hydrolyzed condensate of the silane compounds.

These silane compounds (and hydrolyzed condensates thereof) are used singly or in combination of two or more kinds thereof. Among these, glycidoxytrimethoxysilane and epoxycyclohexylethyltrimethoxysilane containing an epoxy group, and isocyanatopropyltrimethoxysilane containing an isocyanate group are particularly preferable.

These organosilanes are not limited to monomers, and compounds such as dimers or trimers can also be used depending on the structure.

The metal alkoxide is a compound represented by Formula (5):

$M(OR^2)n$ ... (5)

where M is a metal atom,

$R^2$ is an alkyl group as in Formula (4), and
n is an integer indicating the valence of the metal atom M.

Examples of such metal alkoxides include tetraethoxysilane and tripropoxyaluminum. Such metal alkoxides are also used singly or in combination of two or more kinds thereof.

Each of the organoalkoxysilane and the metal alkoxide described above can also be used as the component (D2) in the form of a hydrolyzate.

Such a hydrolyzate can be obtained by a known method using acid or alkali, and a reaction catalyst such as a tin compound can also be used as necessary in hydrolysis.

Examples of the phosphorus compound include phosphoric acid or a salt thereof. Specific examples thereof include orthophosphoric acid, pyrophosphoric acid, metaphosphoric acid, or an alkali metal salt or ammonium salt thereof; condensed phosphoric acids such as trimetaphosphoric acid, tetrametaphosphoric acid, hexametaphosphoric acid, and ultrametaphosphoric acid, or alkali metal salts and ammonium salts thereof; and the like. Phosphate esters such as triphenyl phosphate can also be used.

These phosphorus compounds can also be used singly or in combination of two or more kinds thereof.

The component (D1) and the component (D2) described above are melt-mixed so that the mass ratio (D 1)/(D2) = 99/1 to 70/30 is satisfied, and this molten mixture is applied to the surface of the inorganic barrier layer (A1) to form the protective layer (D).

The thickness of the protective layer (D) formed in this manner is suitably in a range of 0.01 to 50 $\mu$m, particularly 0.1 to 2 $\mu$m.

In the present invention, in the examples of FIGS. 1 and 3, the inorganic barrier layer (A1) is provided only on one surface of the plastic film (A), but of course, the inorganic barrier layer (A1) may be formed on both surfaces of the film (A), and furthermore, the moisture trapping layers (B) may be formed such that the coating layer (C) is interposed between each of the inorganic barrier layers (A1) formed on both surfaces and the corresponding moisture trapping layer (B).

The moisture barrier laminated film 10 of the present invention having the above-described layer structure is stored in a protected state by forming the moisture trapping layer (B) by the above-described procedure, releasing moisture from the moisture trapping layer (B), and then attaching a dry film to the surface of the moisture trapping layer

(B), and the dry film is peeled off at the time of use.

As described above, for example, the moisture trapping layer (B) can be laminated on another barrier film or a moisture trapping layer (B) provided on the other barrier film by dry lamination in which the coating layer (C) is further formed.

The moisture barrier laminated film described above does not cause delamination even in a deterioration promoting test in a high-temperature and high-humidity atmosphere having a temperature of 85°C or higher and a relative humidity RH of 85% or higher, and can exhibit excellent moisture barrier properties, so that the quality can be confirmed in a short time, which is extremely advantageous in industrial applications. Of course, it can also be used as a sealing material of an electronic device used in a use environment under such high-temperature and high-humidity.

Such a moisture barrier laminated film of the present invention can be suitably used particularly as a film for sealing an electronic circuit of an organic EL element, a solar cell, an electronic paper or the like.

## Examples

### Method for Measuring Molecular Weight

To about 10 mg of an isocyanate-reactive resin sample, 3 mL of a solvent was added, and the mixture was gently stirred at room temperature. The dissolution was visually confirmed and then filtration was performed through a 0.45 μm filter, and the filtrate was subjected to GPC measurement (in terms of polystyrene) to measure the weight average molecular weight (Mw). As a standard, polystyrene was used.

Apparatus: HLC-8120 available from Tosoh Corporation
Detector: Differential refractive index detector RI
Column: TSKgel SuperHM-H×2
(TSKguard column SuperH-H as guard column)
Solvent: Chloroform
Flow rate: 0.5 mL/min
Column temperature: 40°C

### Method for Measuring Moisture Permeability

The water vapor permeability of each coating layer (C) was measured at 40°C and 90%RH using PERMATRAN (available from AMETEK MOCON) by forming a film of only each resin layer alone.

### Method for measuring glass transition point Tg and storage modulus E'

A coating film of each coating layer (C) was prepared, and the value when dynamic viscoelasticity measurement was performed under the following conditions was described.

Apparatus: DMS-6100 available from Hitachi High-Tech Science Corporation
Test piece: Size 10 mm × 20 mm, Thickness 60 μm
Measurement temperature: 30 to 130°C

### Method for Calculating Molecular Weight between Crosslinking Points Mc

The molecular weight between crosslinking points Mc was calculated using the following equation:

$$Mc = 3\rho RT/Emin$$

Mc: Molecular weight between crosslinks (g/mol)
ρ: Density of sample coating film (g/cm$^3$)
R: Gas constant (8.314 J/K/mol)
T: Absolute temperature (K) when storage modulus is Emin
Emin: Minimum value of storage modulus (MPa)

Method of Measuring Water Contact Angle θ

Under the condition of 23°C and 50%RH, 3 μL of pure water was placed on the coating layer (C) using a solid-liquid interface analysis system Drop Master 700 (available from Kyowa Interface Science Co., Ltd.), and the water contact angle was measured.

Method for Evaluating Barrier Layer Deterioration

A PET film having a thickness of 100 μm was dry-laminated on the produced moisture barrier laminated film with an adhesive, and for curing the adhesive layer, aging was performed at 50°C for 3 days to produce a sample for a T-type peeling test.

In an atmosphere of 23°C and 50%RH, by a T-type peeling test, the laminate strength (unit: N/15 mm) between the moisture barrier laminated film of the laminate and PET was measured under the measurement condition of a peeling rate of 300 mm/min using a test piece having a width of 15 mm and a length of 200 mm (including a non-adhesive portion of 50 mm) (n = 4).

The value at this time was used as an initial value, and the degree of deterioration was evaluated (initial zone).

After the T-type peeling test sample prepared in the same manner was stored at 85°C and 85%RH for 5 days, 10 days, and 20 days, the same measurement was performed for each sample, and the laminate strength after moisture absorption was measured (Day 5 zone, Day 10 zone, Day 20 zone).

The evaluation criteria are as follows.

Poor: When strength is 1 N/15 mm or less.
Marginal: When strength is more than 1 N/15 mm and 2 N/15 mm or less.
Good: When strength is more than 2 N/15 mm and 3 N/15 mm or less.
Excellent: When strength is more than 3 N/15 mm.

Preparation of Moisture Trapping Layer Coating Liquid (B1) Using Cationic Polymer

Polyallylamine (PAA-15C available from Nittobo Medical Co., Ltd., aqueous solution product, solid content: 15%) as a cationic polymer was diluted with water so as to have a solid content of 5 mass% to obtain a polymer solution.

On the other hand, γ-glycidoxypropyltrimethoxysilane was used as a crosslinking agent, and dissolved in water so as to be 5 mass% to prepare a crosslinking agent solution.

Next, the polymer solution and the crosslinking agent solution were mixed such that the amount of γ-glycidoxypropyltrimethoxysilane was 20 parts by mass with respect to 100 parts by mass of polyallylamine, and further, a crosslinked product of sodium polyacrylate (TAFTIC HU-820E available from Toyobo Co., Ltd., water-dispersed product, solid content: 13%) as a moisture absorbing agent was added to the mixed solution so as to be 420 parts by mass with respect to polyallylamine, and the resulting mixture was further adjusted with water so as to have a solid content of 5%, and then well stirred to prepare a coating liquid (B1) for a moisture trapping layer.

Preparation of Moisture Trapping Layer Coating Liquid (B2) Using Anionic Polymer

Polyacrylic acid (AC-10LP available from Nippon Pure Chemical Industries, Ltd.) as an anionic polymer was dissolved in a water/acetone mixed solvent (80/20 by weight) so that the solid content was 5 mass%, and sodium hydroxide was added so that the neutralization ratio of polyacrylic acid was 80% to obtain a polymer solution.

To this polymer solution, diglycidyl 1,2-cyclohexanedicarboxylate was blended as a crosslinking agent in an amount of 20 parts by mass based on a partially neutralized polyacrylic acid. Subsequently, β-(3,4-epoxycyclohexyl) ethyltrimethoxysilane was blended as an adherence agent so as to be 3 parts by mass based on the partially neutralized polyacrylic acid. To this adherence agent formulation, a granular moisture absorbing agent (TAFTIC HU-820E available from Toyobo Co., Ltd., water-dispersed product, solid content: 13%) was blended so as to be 431 parts by mass based on the partially neutralized polyacrylic acid. Finally, the total solid content was adjusted to 5 mass% with a water/acetone mixed solvent (80/20 by weight) and then well stirred to prepare a coating liquid (B2) for a moisture trapping layer.

Example 1

A polymer solution (solid content: 50%) containing an acrylic resin A (Mw = 70000, glass transition point = 100°C, OHV (hydroxyl value) = 30, glycidyl group content (G content) = 0 mass%) as a base resin was prepared.

Polyisocyanate (Mw = 700) as a curing agent was added to the polymer solution in an amount of 30 parts by mass based on 100 parts by mass of the solid content of the polymer solution, and the mixture was diluted with methyl

ethyl ketone to prepare a coating solution having a solid content of 20%.

A commercially available barrier film (GX available from Toppan Inc., substrate: PET (12 μm)) having a protective layer (D) on an aluminum oxide layer (inorganic barrier layer) was prepared.

The coating solution was applied onto the protective layer (D) of the barrier film with a bar coater, and heat-treated in an electric oven under the conditions of a peak temperature of 100°C and a peak temperature retention time of 1 minute to obtain a coating layer (C) of 1.0 μm.

A moisture trapping layer coating liquid (B 1) using the cationic polymer was applied onto the coating layer (C) with a bar coater, and heat-treated under conditions of a peak temperature of 100°C and a peak temperature retention time of 1 minute to form a moisture trapping layer (B) having a thickness of 3 μm, thereby obtaining a moisture barrier laminated film.

Example 2

As a base resin, a polymer solution (solid content: 50%) containing an acrylic resin A (Mw = 70000, glass transition point = 100°C, OHV = 30, glycidyl group content = 0 mass%) and an acrylic resin B (Mw = 3000, glass transition point = 70°C, OHV = 100, glycidyl group content = 30 mass%) at a solid content ratio of 95/5 was prepared.

A moisture barrier laminated film was obtained in the same manner as in Example 1 except for using this polymer solution.

Example 3

A polymer solution (solid content: 50%) containing an acrylic resin C (Mw = 45000, glass transition point = 95°C, OHV = 45, glycidyl group content = 5 mass%) as a base resin was prepared.

A moisture barrier laminated film was obtained in the same manner as in Example 1 except for using this polymer solution.

Example 4

A moisture barrier laminated film was obtained in the same manner as in Example 3 except that 0.2 parts by mass (corresponding to 0.15 mass% per coating layer) of an amine compound was added as a catalyst based on 100 parts by mass of the acrylic resin.

Example 5

A moisture barrier laminated film was obtained in the same manner as in Example 3 except that 0.2 parts by mass (corresponding to 0.15 mass% per coating layer) of an organotin-based compound was added as a catalyst based on 100 parts by mass of the acrylic resin.

Example 6

A moisture barrier laminated film was obtained in the same manner as in Example 3 except that 0.2 parts by mass (corresponding to 0.15 mass% per coating layer) of an organozinc-based compound was added as a catalyst based on 100 parts by mass of the acrylic resin.

Example 7

A moisture barrier laminated film was obtained in the same manner as in Example 6 except that the catalyst amount is changed to 0.03 parts by mass (corresponding to 0.02 mass% per coating layer) based on 100 parts by mass of the acrylic resin.

Example 8

A moisture barrier laminated film was obtained in the same manner as in Example 6 except that the thickness of the coating layer (C) was set to 0.3 μm.

Example 9

A moisture barrier laminated film was obtained in the same manner as in Example 6 except that the thickness

of the coating layer (C) was set to 0.15 μm.

Example 10

A moisture barrier laminated film was obtained in the same manner as in Example 6 except that the curing agent amount is changed to 15 parts by mass based on 100 parts by mass of the acrylic resin.

Example 11

A moisture barrier laminated film was obtained in the same manner as in Example 6 except that a commercially available barrier film (Barrialox 1011 HG available from TORAY ADVANCED FILM Co., Ltd., substrate: PET 12 μm) having aluminum oxide as an inorganic barrier layer and provided with no protective layer (D) was used.

Example 12

A moisture barrier laminated film was obtained in the same manner as in Example 6 except that a commercially available barrier film (Toppan Inc., GL-RD, substrate: PET 12 μm) having silicon oxide as an inorganic barrier layer and having a protective layer (D) was used.

Example 13

A moisture barrier laminated film was obtained in the same manner as in Example 6 except that a commercially available barrier film (TECHBARRIER L available from Mitsubishi Chemical Corporation, substrate: PET 12 μm) having silicon oxide as an inorganic barrier layer and provided with no protective layer (D) was used.

Example 14

A moisture barrier laminated film was obtained in the same manner as in Example 6 except that the water-moisture trapping layer coating liquid (B2) using the anionic polymer was used.

Example 15

A moisture barrier laminated film was obtained in the same manner as in Example 6 except that a 1.0 μm coating layer (C) was further formed on the moisture trapping layer (B) in Example 6.

Comparative Example 1

A moisture barrier laminated film was obtained in the same manner as in Example 1 except that the coating layer (C) was not formed, and the coating liquid (B 1) for a moisture trapping layer having a cationic polymer was applied onto the protective layer (D) of the barrier film to form the moisture trapping layer (B) having a thickness of 3 μm.

Comparative Example 2

A polymer solution (solid content: 30%) containing a water-dispersed urethane resin (Mw = 1000000, glass transition point = 68°C, OHV = 25, glycidyl group content = 0 mass%) as a base resin was prepared.
Blocked isocyanate (Mw = 2500) as a curing agent was added to the polymer solution so that a solid content of the curing agent was 10 parts by mass based on 100 parts by mass of the solid content of the polymer solution, and the mixture was diluted with a mixed solvent of water and 2-propanol to prepare a coating solution having a solid content of 20%.
A moisture barrier laminated film was obtained in the same manner as in Example 1 except for using this coating solution.

Comparative Example 3

A polymer solution (solid content: 40%) containing an acrylic resin D (Mw = 69000, glass transition point = 70°C, OHV = 80, glycidyl group content = 0 mass%) as a base resin was prepared.
A moisture barrier laminated film was obtained in the same manner as in Example 1 except for using this polymer solution.

Materials used in the formation of the respective layers and presence or absence of the protective layer are shown in Tables 1 and 2 for Examples and Comparative Examples described above.

Note that meanings of abbreviations used in Tables 1 and 2 are as follows.

AlO: Aluminum oxide
SiO: Silicon oxide
Am: Amine-based catalyst
Sn: Organotin-based catalyst
Zn: Organozinc-based catalyst
M polymer: Matrix polymer

In the tables, the amount of curing agent is indicated by parts by mass per 100 parts by mass of the base resin.

Evaluation Test

For the moisture barrier laminated films of Examples and Comparative Examples prepared above, in addition to the thickness of the coating layer, the glass transition point Tg, the moisture permeability, the storage modulus E', and the water contact angle θ of the coating layer, and the deterioration evaluation of the barrier layer were measured by the methods described above, and the results are shown in Tables 3 and 4.

[Table 1]

| | Inorganic barrier layer (A1) | Protective layer (D) | Moisture trapping layer (B) | Coating layer (C) | | | | |
|---|---|---|---|---|---|---|---|---|
| | | | | Base resin | | | Curing agent (amount) | Catalyst (content) |
| | | | Ionicity of M polymer | Type | G Content | OHV | | |
| Example 1 | AlO | Present | Ionic | Acrylic resin A | 0 | 30 | Isocyanate (30) | None |
| Example 2 | AlO | Present | Cationic | Acrylic resins A, B | 2.5 | 33 | Isocyanate (30) | None |
| Example 3 | AlO | Present | Cationic | Acrylic resin C | 5 | 45 | Isocyanate (30) | None |
| Example 4 | AlO | Present | Cationic | Acrylic resin C | 5 | 45 | Isocyanate (30) | Am 0.15 |
| Example 5 | AlO | Present | Cationic | Acrylic resin C | 5 | 45 | Isocyanate (30) | Sn 0.15 |
| Example 6 | AlO | Present | Cationic | Acrylic resin C | 5 | 45 | Isocyanate (30) | Zn 0.15 |
| Example 7 | AlO | Present | Cationic | Acrylic resin C | 5 | 45 | Isocyanate (30) | Zn 0.02 |
| Example 8 | AlO | Present | Cationic | Acrylic resin C | 5 | 45 | Isocyanate (30) | Zn 0.15 |
| Example 9 | AlO | Present | Cationic | Acrylic resin C | 5 | 45 | Isocyanate (30) | Zn 0.15 |
| Example 10 | AlO | Present | Cationic | Acrylic resin C | 5 | 45 | Isocyanate (15) | Zn 0.15 |

[Table 2]

| | Inorganic barrier layer (A1) | Protective layer (D) | Moisture trapping layer (B) | Coating layer (C) | | | | |
|---|---|---|---|---|---|---|---|---|
| | | | | Base resin | | | Curing agent (amount) | Catalyst (content) |
| | | | Ionicity of M polymer | Type | G content | OHV | | |
| Example 11 | AIO | None | Cationic | Acrylic resin C | 5 | 45 | Isocyanate (30) | Zn 0.15 |
| Example 12 | SiO | Present | Cationic | Acrylic resin C | 5 | 45 | Isocyanate (30) | Zn 0.15 |
| Example 13 | SiO | None | Cationic | Acrylic resin C | 5 | 45 | Isocyanate (30) | Zn 0.15 |
| Example 14 | AIO | Present | Anionic | Acrylic resin C | 5 | 45 | Isocyanate (30) | Zn 0.15 |
| Example 15 | AIO | Present | Cationic | Acrylic resin C | 5 | 45 | Isocyanate (30) | Zn 0.15 |
| Comparative Example 1 | AIO | Present | Cationic | - | - | - | - | - |
| Comparative Example 2 | AIO | Present | Cationic | Urethane resin | 0 | 25 | Isocyanate (10) | None |
| Comparative Example 3 | AIO | Present | Cationic | Acrylic resin D | 0 | 80 | Isocyanate (30) | None |

[Table 3]

| | Coating layer (C) | | | | | Barrier layer degradation evaluation 85°C 85%RH | | | |
|---|---|---|---|---|---|---|---|---|---|
| | Thickness (μm) | Tg (°C) | Moisture permeability at40°C 90%RH (g/m$^2$/day) | E' at 85°C (MPa) | 0 at23°C 50%RH(°) | Initial zone | Day 5 zone | Day 10 zone | Day 20 zone |
| Example 1 | 1.0 | 98 | 13000 | 145 | 67 | Good | Good | Good | Poor |
| Example 2 | 1.0 | 96 | 13000 | 140 | 67 | Good | Good | Good | Poor |
| Example 3 | 1.0 | 95 | 8000 | 300 | 82 | Good | Good | Good | Good |
| Example 4 | 1.0 | 95 | 8000 | 300 | 82 | Good | Good | Good | Good |
| Example 5 | 1.0 | 95 | 8000 | 300 | 82 | Excellent | Excellent | Excellent | Excellent |
| Example 6 | 1.0 | 95 | 8000 | 300 | 82 | Excellent | Excellent | Excellent | Excellent |
| Example 7 | 1.0 | 95 | 8000 | 300 | 82 | Excellent | Excellent | Excellent | Excellent |
| Example 8 | 0.3 | 95 | 25000 | 300 | 82 | Excellent | Excellent | Good | Marginal |
| Example 9 | 0.15 | 95 | 55000 | 300 | 82 | Excellent | Good | Marginal | Poor |
| Example 10 | 1.0 | 95 | 10000 | 70 | 84 | Excellent | Excellent | Excellent | Excellent |

[Table 4]

| | Coating layer (C) | | | | | Barrier layer degradation evaluation 85°C 85%RH | | | |
|---|---|---|---|---|---|---|---|---|---|
| | Thickness (μm) | Tg (°C) | Moisture permeability at 40°C 90%RH (g/m²/day) | E' at 85°C (MPa) | θ at23°C 50%RH(°) | Initial zone | Day 5 zone | Day 10 zone | Day 20 zone |
| Example 11 | 1.0 | 95 | 8000 | 300 | 82 | Excellent | Excellent | Excellent | Excellent |
| Example 12 | 1.0 | 95 | 8000 | 300 | 82 | Excellent | Excellent | Excellent | Excellent |
| Example 13 | 1.0 | 95 | 8000 | 300 | 82 | Excellent | Excellent | Excellent | Excellent |
| Example 14 | 1.0 | 95 | 8000 | 300 | 82 | Excellent | Excellent | Excellent | Excellent |
| Example 15 | 1.0 | 95 | 8000 | 300 | 82 | Excellent | Excellent | Excellent | Excellent |
| Comparative Example 1 | - | - | - | - | - | Good | Poor | Poor | Poor |
| Comparative Example 2 | 1.0 | 90 | 65000 | 100 | 53 | Good | Poor | Poor | Poor |
| Comparative Example 3 | 1.0 | 80 | 21000 | 10 | 70 | Good | Poor | Poor | Poor |

Reference Signs List

(A) Plastic film
(A1) Inorganic barrier layer
(B) Moisture trapping layer
(C) Coating layer
(D) Protective layer
10 Moisture barrier laminated film

## Claims

1. A moisture barrier laminated film comprising:

    a plastic film (A) having an inorganic barrier layer (A1);
    a moisture trapping layer (B) containing an alkali component; and
    a coating layer (C) provided between the inorganic barrier layer (A1) and the moisture trapping layer (B), wherein in the coating layer (C), a moisture permeability at 40°C and 90%RH is $6.0 \times 10^4$ g/m$^2$/day or less, and a storage modulus E' (at $2\pi$ rad/s) in viscoelasticity measurement at 85°C is 30 MPa or more.

2. The moisture barrier laminated film according to claim 1, wherein the coating layer (C) is formed of a urethane (meth)acrylate polymer.

3. The moisture barrier laminated film according to claim 2, wherein the coating layer (C) contains a catalyst in a range of 0.02 to 1.0 mass%.

4. The moisture barrier laminated film according to claim 3, wherein the catalyst is a metal catalyst.

5. The moisture barrier laminated film according to claim 2, wherein the urethane (meth)acrylate polymer has a high glass transition point of 85°C or higher.

6. The moisture barrier laminated film according to claim 1, wherein a protective layer (D) is provided between the inorganic barrier layer (A1) and the coating layer (C).

7. The moisture barrier laminated film according to claim 6, wherein the protective layer (D) contains not only a water-soluble polymer (D1) but also at least one component (D2) selected from the group consisting of:

    organoalkoxysilane or hydrolyzate thereof;
    metal alkoxide or hydrolyzate thereof; and
    a phosphorus compound.

8. The moisture barrier laminated film according to claim 1, wherein the coating layer (C) is also provided on a side of the moisture trapping layer (B) opposite to the inorganic barrier layer (A1).

9. A sealing material for an electronic device, the sealing material comprising the moisture barrier laminated film according to claim 1.

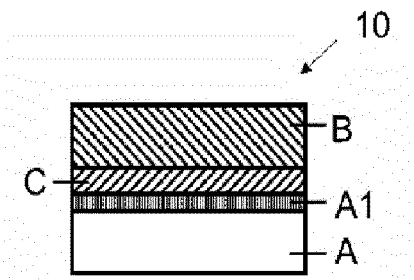


FIG. 1

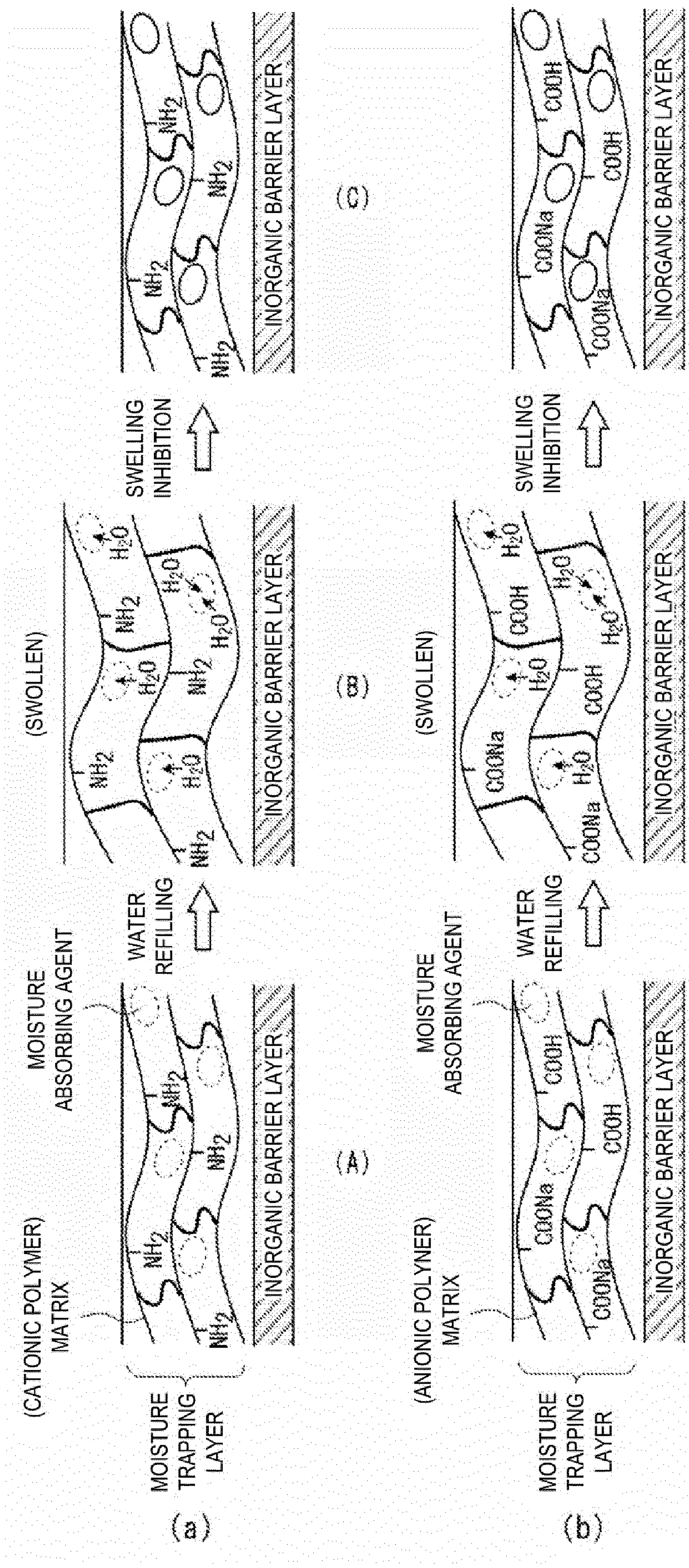
(a)
(CATIONIC POLYMER) MATRIX
MOISTURE TRAPPING LAYER
MOISTURE ABSORBING AGENT
NH2
INORGANIC BARRIER LAYER
(A)
WATER REFILLING
(SWOLLEN)
H2O
(B)
SWELLING INHIBITION
(C)
(b)
(ANIONIC POLYNER) MATRIX
MOISTURE TRAPPING LAYER
MOISTURE ABSORBING AGENT
COONa
COOH
INORGANIC BARRIER LAYER
WATER REFILLING
(SWOLLEN)
H2O
SWELLING INHIBITION

FIG. 2

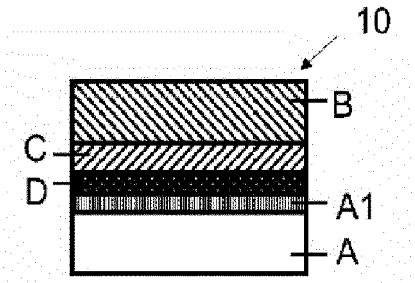


FIG. 3

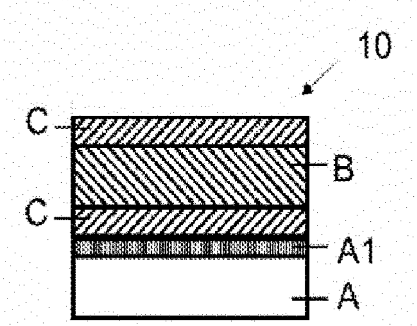


FIG. 4

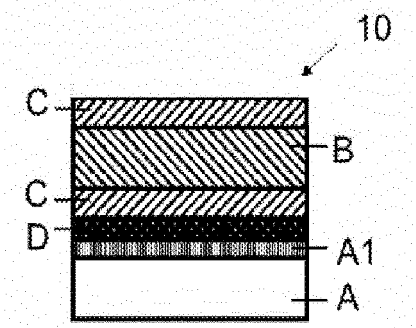


FIG. 5

## INTERNATIONAL SEARCH REPORT

International application No.
PCT/JP2021/012886

A. CLASSIFICATION OF SUBJECT MATTER
Int. Cl. B32B9/00(2006.01)i, B32B27/00(2006.01)i, H05B33/04(2006.01)i, H01L51/50(2006.01)i
FI: B32B27/00 B, B32B9/00 A, H05B33/14 A, H05B33/04
According to International Patent Classification (IPC) or to both national classification and IPC

B. FIELDS SEARCHED
Minimum documentation searched (classification system followed by classification symbols)
Int. Cl. B32B9/00, B32B27/00, H05B33/04, H01L51/50

Documentation searched other than minimum documentation to the extent that such documents are included in the fields searched
Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2019/093357 A1 (TOYO SEIKAN GROUP HOLDINGS, LTD.) 16 May 2019, claims, paragraphs [0035], [0079], examples 1-15, fig. 1-3 | 1-2, 5-9<br>3-4 |
| X<br>Y | JP 2019-84747 A (TOYO SEIKAN GROUP HOLDINGS, LTD.) 06 June 2019, claims, example 13, fig. 1, 2 | 1-2, 5-9<br>3-4 |
| Y | JP 2019-34466 A (TOYO SEIKAN GROUP HOLDINGS, LTD.) 07 March 2019, paragraph [0027] | 3-4 |
| Y | JP 2020-41101 A (DAICEL ALLNEX CO., LTD.) 19 March 2020, paragraph [0078] | 3-4 |
| Y | JP 9-316423 A (NIPPON POLYURETHANE INDUSTRY CO., LTD.) 09 December 1997, paragraph [0036] | 3-4 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 31.05.2021 | 22.06.2021 |
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

INTERNATIONAL SEARCH REPORT

International application No. PCT/JP2021/012886

C (Continuation). DOCUMENTS CONSIDERED TO BE RELEVANT

| Category* | Citation of document, with indication, where appropriate, of the relevant passages | Relevant to claim No. |
|---|---|---|
| A | JP 2019-34539 A (TOYO SEIKAN GROUP HOLDINGS, LTD.) 07 March 2019, claims, examples 1-7 | 1-9 |
| A | JP 2019-171771 A (TOYO SEIKAN GROUP HOLDINGS, LTD.) 10 October 2019, claims, examples 1-8 | 1-9 |

Form PCT/ISA/210 (continuation of second sheet) (January 2015)

**INTERNATIONAL SEARCH REPORT**
Information on patent family members

International application No.
PCT/JP2021/012886

| Patent Documents referred to in the Report | Publication Date | Patent Family | Publication Date |
|---|---|---|---|
| WO 2019/093357 A1 | 16.05.2019 | CN 111315570 A<br>KR 10-2020-0078632 A | |
| JP 2019-84747 A | 06.06.2019 | (Family: none) | |
| JP 2019-34466 A | 07.03.2019 | (Family: none) | |
| JP 2020-41101 A | 19.03.2020 | WO 2020/054582 A1<br>paragraph [0080] | |
| JP 9-316423 A | 09.12.1997 | (Family: none) | |
| JP 2019-34539 A | 07.03.2019 | WO 2019/035326 A1 | |
| JP 2019-171771 A | 10.10.2019 | WO 2019/189805 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000255579 A
- JP 2015096320 A
- JP 2020183064 A
- JP 2019087677 A